# EUROPÄISCHE PATENTSCHRIFT

(11) **EP 0 326 897 B1**
(45) Veröffentlichungstag und Bekanntmachung des Hinweises auf die Patenterteilung: **05.04.1995**
(21) Anmeldenummer: 89101130.6
(22) Anmeldetag: 23.01.1989
(51) Int. Cl.: G06F 7/50, H03K 17/56

(54) **Addierzelle mit einem Summen- und einem Carryteil**
Adder cell with sum and carry parts
Cellule d'addition ayant une partie de somme et une partie de retenue

(30) Priorität: 05.02.1988 DE 3803542
(43) Veröffentlichungstag der Anmeldung: 09.08.1989
(73) Patentinhaber: SIEMENS AKTIENGESELLSCHAFT, 80333 München (DE)
(72) Erfinder: Heimsch, Wolfgang, Dr., D-8000 München 19 (DE); Müllner, Ernst, Dipl.-Ing., D-8000 München 2 (DE)

(56) Entgegenhaltungen:
- US-A- 3 519 810
- ELECTRONIQUE INDUSTRIELLE (SUPPL.), Nr. 13, Juni 1987, Seiten 23-28; L.T. LIN et al.: "Reseaux logiques BICMOS à la demande"
- RADIO FERNSEHEN ELEKTRONIK, Band 35, Nr. 11, 1986, Seite 739; ANONYMOUS: "Abtast- und Halteschaltung"
- IEEE JOURNAL OF SOLID-STATE CIRCUITS, Band SC-21, Nr. 5, Oktober 1986, Seiten 808-813; T. HOTTA et al.: "CMOS/bipolar circuits for 60-MHz digital processing"

## Beschreibung

Die Erfindung betrifft eine Addierzelle mit einem Summen- und einem Carryteil.

Bei einer großen Anzahl von digitalen Logikschaltungen, beispielsweise digitalen Filtern, Signalprozessoren und Mikroprozessoren werden Addierer benötigt. Das einfachste Prinzip für einen solchen Addierer ist das "Ripple-Carry"-Verfahren, bei dem ein entstehender Übertrag (Carry) seriell von einer Addiererzelle für das jeweils niederwertige Bit zu einer Addiererzelle für das jeweils höherwertige Bit übertragen wird. Die Durchlaufzeit das Übertragssignals bestimmt dabei im wesentlichen die Additionszeit. Auch aufwendigere Addiererprinzipien, wie z. B. das bekannte "Carry-Look-Ahead"-Verfahren, bauen auf Elementen des "Ripple-Carry"-Verfahrens auf.

Addiererzellen zum Aufbau von Addieren für die oben angeführten Additionsverfahren in MOS-Schaltungstechnik sind beispielsweise aus H. Weiß, K. Horninger: "Integrierte MOS-Schaltungen", Springer-Verlag, Berlin-Heidelberg-New York (1982), auf den Seiten 188-194 bekannt. Weitere Ausführung formen sind z.B. in US-A-3 519 810 beschrieben.

Neben der MOS-Schaltungstechnik hat sich in den letzten Jahren eine Bipolar-CMOS(BICMOS)-Schaltungstechnologie entwickelt, die besonders bei zeitkritischen und kompakten Schaltungen eingesetzt wird. Durch die Verwendung von "BICMOS"-Schaltungen ergeben sich Vorteile sowohl aus der MOS- als auch aus der Bipolar-Schaltungstechnologie. Hohe Packungsdichten und keine statische Verlustleistung, welche beispielsweise für Schaltungen aus der CMOS-Schaltungstechnik charakteristisch sind, eine geringe Offsetspannung sowie eine sehr hohe Verarbeitungsgeschwindigkeit, welche für Schaltungen in ECL- bzw. Bipolarschaltungstechnik kennzeichnend sind, sind Merkmale, die für eine Verwendung von Schaltungen in "BICMOS"-Schaltungstechnologie sprechen. Aus der technischen Literatur sind ebenfalls CMOS/Bipolarschaltungen für Addierer bekannt. In der Veröffentlichung IEEE Journal of Solid State Circuits, Vol. SC-21, No. 5, Okt. 1986, CMOS/Bipolar Circuits for 60 MHz Digital Processing, von Takashi Hotta et al ist in Fig. 7 eine 4-Bit-Recheneinheit angegeben, die aus Halbaddierer, einer "Carry-Generation"-Schaltung und einer "Carry-Propagation"-Schaltung besteht. In Fig. 8 und auf den Seiten 810 bzw. 811 ist die "Carry-Propagation"-Schaltung näher beschrieben, wobei in dieser Figur auch die Anwendung der "BICMOS"-Schaltungstechnologie erkennbar ist. Die "Carry-Propagation"-Schaltung enthält sowohl MOS-Transistoren als auch einen Bipolartransistor. Als Eingangssignale für diese Schaltung sind CMOS-Pegel zwischen 0 und 5 Volt vorgesehen, während an dem Ausgang dieser Schaltung ECL-Hübe im Millivoltbereich abgegriffen werden können.

Bei der Schaltung in der zuletzt genannten Veröffentlichung, wird die Umsetzung der Eingangs-/Ausgangspegel und die Logikverarbeitung jeweils in getrennten Stufen vorgenommen. Hierbei dient in Fig. 8 ein Bipolarausgangstransistor zur Umwandlung in CMOS-Pegel, während die übrigen MOS-Transistoren der Schaltung für die Logikfunktion der Schaltung zuständig ist. Eine solche Schaltung nutzt die Geschwindigkeitsvorteile der "BICMOS"-Schaltungstechnologie nicht voll aus. Den bekannten Addiererzellen in der MOS-Schaltungstechnik haftet der Nachteil an, daß in dem Übertragspfad, der zeitkritsch für die gesamte Rechenzeit eines mit derartigen Addiererzellen aufgebauten Rechenwerks ist, entweder eine verhältnismäßig große Anzahl von Gattern eingefügt ist und/oder daß die in den Übertragspfad eingefügten Gatter Bestandteile von Kombinationsgattern sind. Im ersteren Fall wirkt sich die Anzahl von in Reihe geschalteten Gattern ungünstig auf die Durchlaufzeit von Übertragungssignalen aus. Im zweiten Fall wirkt sich unter Umständen zusätzlich die Tatsache ungünstig aus, daß die Aufladung der Kapazität des Übertragsausgangs aufgrund der relativen Hochohmigkeit der als Bestandteile von Kombinationsgattern ausgebildeten Gatter nicht mit der erforderlichen Flankensteilheit erfolgt.

Der Erfindung liegt die Aufgabe zugrunde, Addiererzellen mit einem Summations- und einem Carryteil vorzustellen, bei der die Nachteile bekannter Addiererzellen bezüglich des Übertragspfades wirksam vermieden werden kann und die außerdem einen geringen Flächen- und Leistungsbedarf erfordern.

Diese Aufgabe wird erfindungsgemäß durch die kennzeichnenden Merkmale im Patentanspruch 1 und Patentanspruch 5 gelöst.

Eine weitere Ausgestaltung der Erfindung ist in den Unteransprüchen angegeben und wird in diesen näher erläutert.

Die mit der Erfindung erzielten Vorteile bestehen insbesondere darin, daß die Addierzelle mit einem Summen- und einem Carryteil eine erheblich höhere Verarbeitungsgeschwindigkeit aufweist als Addierzellen in MOS-Schaltungstechnik. Die Vorteile der bipolaren bzw. ECL-Schaltungstechnik, wie geringe Offsetspannung und schnelle Verarbeitungsgeschwindigkeit sind weitere Vorteile dieser Addierzelle.

Zwei Ausführungsbeispiele sind in den Figuren 2 und 3 bzw. Figur 4 und 5 wiedergegeben und werden im folgenden näher beschrieben. Es zeigen
- Figur 1: die Zusammenschaltung der Addierzellen mit je einem Summen- und je einem Carryteil zu einem gesamten Addierer,
- Figur 2: ein erstes Ausführungsbeispiel für den Summenteil der Addierzelle,
- Figur 3: ein zweites Ausführungsbeispiel für den Summenteil der Addierzelle,
- Figur 4: ein erstes Ausführungsbeispiel für den Carryteil der Addierzelle,
- Figur 5: ein zweites Ausführungsbeispiel für den Carryteil der Addierzelle,
- Figur 6: eine Wahrheitstabelle für die Addierzelle.

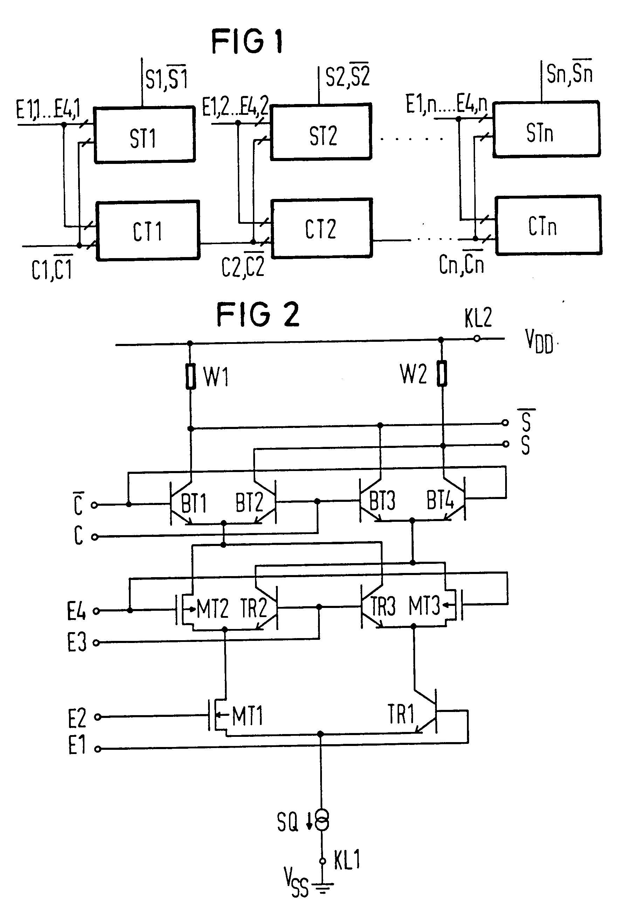

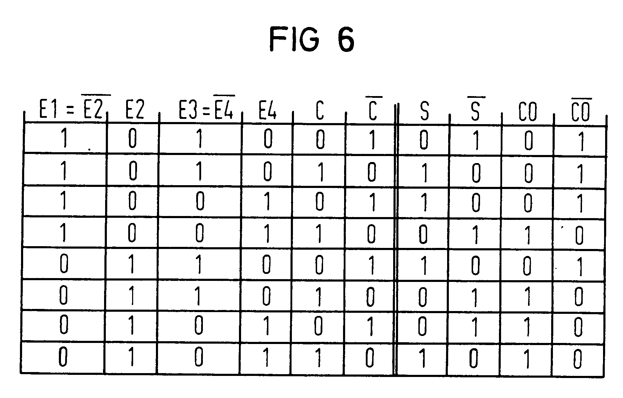

Figur 1 zeigt die Verschaltung von n Addierzellen mit jeweils einem Summen- und einem Carryteil. Auf die erste Addierzelle, bestehend aus einem ersten Summen- ST1 und einem ersten Carryteil CT1, sind jeweils Eingangssignale auf die vier Eingänge E1,1 ... E4,1 und zwei Carryeingangssignale auf die zwei Carryeingänge C1, C̅1̅ geschaltet. Die beiden Carryeingangssignale werden im ersten Carryteil CT1 auf einen festen "0"- bzw. "1"-Pegel gelegt. Carryausgangssignale aus dem ersten Carryteil CT1 bilden gleichzeitig die Carryeingangssignale an den zwei Carryeingängen C2, C̅2̅ für den zweiten Carryteil CT2 der zweiten Addierzelle. Diese Carryeingangssignale sind ebenfalls auf den zweiten Summenteil ST2 der zweiten Addierzelle geschaltet. Der zweite Summenteil ST2 als auch der zweite Carryteil CT2 sind ebenfalls wieder jeweils mit Eingangssignalen auf den vier Eingängen E1,2 ... E4,2 beschaltet. Die angegebene Verschaltung gilt für alle übrigen Addierzellen, so daß die n-te Addierzelle mit dem n-ten Summenteil STn und dem n-ten Carryteil CTn wiederum jeweils mit Carryeingangssignalen auf zwei Carryeingängen Cn, C̅n̅ und jeweils mit Eingangssignale auf vier Eingängen E1,n ...E4,n belegt ist. Die einzelnen Addierzellen weisen jeweils zwei Summenausgänge auf, die für den ersten Summenteil mit S1, S̅1̅, für den zweiten Summenteil mit S2, S̅2̅ bzw. für den n-ten Summenteil Sn, S̅n̅ angegeben sind. Die Belegung der Eingangssignale für die einzelnen Addierzellen ist abhängig von dem gewählten Ausführungsbeispiel des Summenteils bzw. des Carryteils. Dies wird in den nachfolgenden Figuren 2 bis 6 nochmals näher erläutert. Die Carryeingangssignale an den Carryeingängen C1, C̅1̅ bzw. C2, C̅2̅ oder auch Cn, C̅n̅ sowie die Summenausgangssignale an den Summenausgängen S1, S̅1̅ bzw. S2, S̅2̅ oder auch Sn, S̅n̅ beinhalten jeweils komplementäre Signale. Die Belegung der einzelnen Carrysignale bzw. der Summenausgangssignale sind in Figur 6 in Tabellenform nochmals näher angegeben.

Figur 2 zeigt ein erstes Ausführungsbeispiel für einen Summenteil der Addierzelle. Der Summenteil enthält hierbei einen ersten Differenzverstärker mit einem ersten MOS-Transistor MT1 und einen ersten Transistor TR1, einen zweiten Differenzverstärker mit einem zweiten MOS-Transistor MT2 und einen zweiten Transistor TR2, einen dritten Differenzverstärker mit einem dritten MOS-Transistor MT3 und einem dritten Transistor TR3 sowie einen vierten Differenzverstärker, bestehend aus einem ersten und zweiten Bipolartransistor BT1, BT2, und einem fünften Differenzverstärker, bestehend aus einem dritten und vierten Bipolartransistor BT3, BT4 sowie eine Konstantstromquelle SQ und einen ersten und zweiten Widerstand W1 und W2. Nach Figur 2 ist ein erster Anschluß des ersten MOS-Transistors MT1 und ein erster Anschluß des ersten Transistors TR1 gemeinsam über die Konstantstromquelle SQ mit einer ersten Klemme KL1 verbunden und ein erster Anschluß des zweiten MOS-Transistors MT2 und ein erster Anschluß des zweiten Transistors TR2 ist mit einem zweiten Anschluß des ersten MOS-Transistors MT1 und ein erster Anschluß des dritten MOS-Transistors MT3 und ein erster Anschluß des dritten Transistors TR3 ist mit einem zweiten Anschluß des ersten Transistors TR1 verschaltet. Ein erster Anschluß des ersten Bipolartransistors BT1 und ein erster Anschluß des zweiten Bipolartransistors BT2 sind an einen zweiten Anschluß des zweiten MOS-Transistors MT2 und an einen zweiten Anschluß des dritten Transistors TR3 aufgeschaltet und ein erster Anschluß des dritten Bipolartransistors BT3 und ein erster Anschluß des vierten Bipolartransistors BT4 ist mit einem zweiten Anschluß des zweiten Transistors TR2 und mit einem zweiten Anschluß des dritten MOS-Transistors MT3 verschaltet. Ein zweiter Anschluß des ersten Bipolartransistors BT1 und ein zweiter Anschluß des dritten Bipolartransistors BT3 sind gemeinsam über einen ersten Widerstand W1 mit einer zweiten Klemme KL2 verschaltet und ein zweiter Anschluß des zweiten Bipolartransistors BT2 und ein zweiter Anschluß des vierten Bipolartransistors BT4 sind gemeinsam über einen zweiten Widerstand W2 ebenfalls mit der zweiten Klemme KL2 verbunden. Ein erster Eingang E1 ist mit einem Steueranschluß des ersten Transistors TR1, ein zweiter Eingang E2 mit einem Gateanschluß des ersten MOS-Transistors MT1 verschaltet und ein Steueranschluß des zweiten Transistors TR2 und ein Steueranschluß des dritten Transistors TR3 bilden gemeinsam einen dritten Eingang E3 und ein Gateanschluß des zweiten MOS-Transistors MT2 und ein Gateanschluß des dritten MOS-Transistors MT3 bilden wiederum einen vierten Eingang E4. Ein erster Carryeingang C für ein nicht invertiertes Carrysignal ist an einen Basisanschluß des zweiten Bipolartransistors BT2 und an einen Basisanschluß des dritten Bipolartransistors BT3 geschaltet, während ein zweiter Carryeingang C̅ für ein invertiertes Carrysignal mit einem Basisanschluß des ersten Bipolartransistors BT1 und einem Basisanschluß des vierten Bipolartransistors BT4 verbunden ist. Ein erster Summenausgang S für ein nicht invertiertes Summenausgangssignal ist nach Figur 2 mit dem zweiten Anschluß des vierten Bipolartransistors BT4 und mit dem zweiten Anschluß des zweiten Bipolartransistors BT2 verschaltet, während ein zweiter Anschluß des ersten Bipolartransistors BT1 und ein zweiter Anschluß des dritten Bipolartransistors BT3 gemeinsam einen zweiten Summenausgang S̅ für ein invertiertes Summenausgangssignal bilden. Die erste Klemme KL1 ist in der Verschaltung des Summenteils mit der Masse V_{SS} und die zweite Klemme KL2 mit der Versorgungsspannung V_{DD} belegt.

Der Summenteil der Addierzelle nach Figur 2 sieht für den ersten MOS-Transistor MT1 einen n-Kanal-MOS-Transistors, für den zweiten und dritten MOS-Transistor MT2, MT3 einen p-Kanal-MOS-Transistor und für den ersten, zweiten und dritten Transistor TR1, TR2, TR3 sowie für den ersten, zweiten, dritten und vierten Bipolartransistor BT1, BT2, BT3 und BT4 einen npn-Bipolartransistor vor.

In diesem Ausführungsbeispiel werden die zu summierenden CMOS-Eingangssignale auf den zweiten und vierten Eingang E2, E4 geschaltet, während auf den ersten und dritten Eingang entsprechende Referenzsignale, innerhalb des Low- und High-Pegels der CMOS-Eingangssignale, angelegt werden.

Durch den Einsatz der "BICMOS"-Schaltungstechnik kann die Geschwindigkeit des Summenteils erheblich gegenüber einer Ausführung in reiner CMOS-Schaltungstechnologie gesteigert werden. Durch die Auslegung des vierten und fünften Differenzverstärkers in Bipolar- bzw. ECL-Technik weist der besonders zeitkritische Pfad für die Carrysignale eine besonders hohe Verarbeitungsgeschwindigkeit auf. Während auf der Eingangsseite E1, E2, E3 und E4 CMOS-Pegel zwischen 0 und 5 Volt erforderlich sind, werden für die Carrysignale am ersten und zweiten Carryeingang C, C̅ lediglich ECL-Hübe im Millivoltbereich erforderlich. Ebenfalls liefern die beiden Summenausgänge S, S̅ ECL-Hübe, die zwischen 0 und einigen 100 Millivolt liegen. Dies ist der Fall, wenn der erste und zweite Widerstand W1, W2 in der Dimensionierung ungefähr 200 Ohm beträgt. Der Ausgangshub des Summensignals an den Summenausgängen S, S̅ ist jedoch nicht nur von den Widerständen W1 und W2 abhängig, sondern ebenfalls von der Konstantstromquelle SQ, die sowohl in bipolarer als auch in MOS-Schaltungstechnik realisiert werden kann. Der Platzvorteil ergibt sich durch eine wesentlich geringere Anzahl von Bauelementen, der dadurch entsteht, daß sog. Pegelwandler, die CMOS-Schaltungspegel auf ECL-Pegel wandeln, entfallen. Der Leistungsvorteil des Summenteils nach Figur 2 ergibt sich durch eine geringere Anzahl von Querströmen in der Schaltung.

Eine andere Konfiguration der Transistoren ist für den Summenteil nach Figur 2 ebenfalls möglich. Hierbei ist der erste MOS-Transistor MT1 und der erste Transistor TR1 ein n-Kanal-MOS-Transistor, der zweite und dritte MOS-Transistor MT2, MT3 und der zweite und dritte Transistor TR2, TR3 ist als p-Kanal-MOS-Transistor und der erste, zweite, dritte und vierte Bipolartransistor BT1, BT2, BT3 und BT4 ist als npn-Bipolartransistor ausgeführt. Der Vorteil besteht in einem geringeren Flächenbedarf, während die größere Laufzeit durch die höhere Anzahl von MOS-Transistoren die Verarbeitungsgeschwindigkeit des Summenteils verringern. Die zuletzt angeführte Ausführungsform erfordert komplementäre Eingangssignale, so daß ein Eingangssignal am ersten Eingang E1 ein komplementäres Eingangssignal zu dem Eingangssignal am zweiten Eingang E2 und ein Eingangssignal am dritten Eingang E3 ein komplementäres Eingangssignal zu dem Eingangssignal am vierten Eingang E4 erfordert.

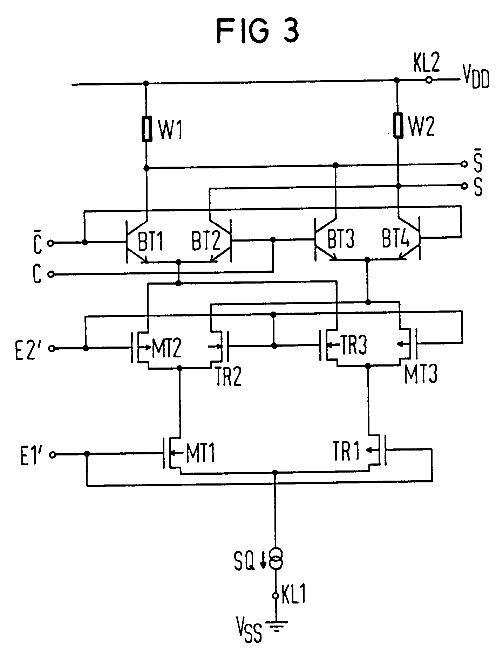

Eine zweite Lösungsmöglichkeit für den Summenteil ist in Figur 3 dargestellt. Die Verschaltung ist grundsätzlich wie in dem Summenteil nach Figur 2 vorzunehmen, so daß gleiche Bezugszeichen in Figur 2 und Figur 3 Verwendung finden. Jedoch ist im Summenteil der erste MOS-Transistor MT1, der zweite und dritte Transistor TR2 und TR3 ein n-Kanal-MOS-Transistor und der erste Transistor TR1 und der zweite und dritte MOS-Transistor MT2, MT3 ein p-Kanal-MOS-Transistor, während der erste, zweite, dritte und vierte Bipolartransistor BT1, BT2, BT3 und BT4 wiederum ein npn-Bipolartransistor ist. Durch die Ausführung des Summenteils nach Figur 3 sind keine komplementären Eingangssignale mehr erforderlich und die Eingänge können paarweise zu einem ersten und zweiten gemeinsamen Eingang E1′, E2′ zusammengefaßt werden. Der erste gemeinsame Eingang E1′ ist durch eine gemeinsame Verschaltung des ersten und zweiten Eingangs E1, E2 und der zweite gemeinsame Eingang E2′ durch eine gemeinsame Verschaltung des dritten und vierten Eingangs E3, E4 gegeben. Für den Summenteil nach Figur 3 ergibt sich wiederum der Vorteil eines geringeren Flächenbedarfs, da keine komplementären Eingangssignale erforderlich sind. Von Nachteil ist eine niedrigere Verarbeitungsgeschwindigkeit gegenüber einem Summenteil im ersten Ausführungsbeispiel nach Fig. 2.

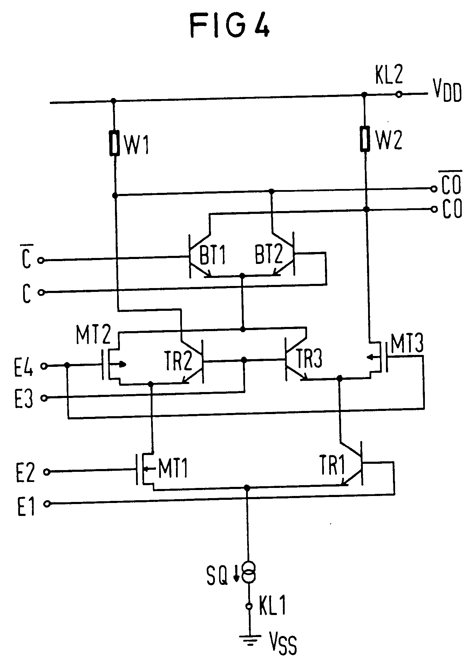

Figur 4 zeigt ein erstes Ausführungsbeispiel für den Carryteil der Addierzelle. Der Carryteil enthält einen ersten Differenzverstärker mit einem ersten MOS-Transistor MT1 und einen ersten Transistor TR1, einen zweiten Differenzverstärker mit einem zweiten MOS-Transistor MT2 und einem zweiten Transistor TR2, einem dritten Differenzverstärker mit einem dritten MOS-Transistor MT3 und einem dritten Transistor TR3 und einen vierten Differenzverstärker, bestehend aus einem ersten und zweiten Bipolartransistor BT1, BT2, eine Konstantstromquelle SQ und einen ersten und zweiten Widerstand W1, W2. Ein erster Anschluß des ersten MOS-Transistors MT1 und ein erster Anschluß des ersten Transistors TR1 sind gemeinsam über die Konstantstromquelle SQ mit einer ersten Klemme KL1 verbunden und ein erster Anschluß des zweiten MOS-Transistors MT2 und ein erster Anschluß des zweiten Transistors TR2 sind mit einem zweiten Anschluß des ersten MOS-Transistors MT1 und ein erster Anschluß des dritten Transistors TR3 und ein erster Anschluß des dritten MOS-Transistors MT3 sind mit einem zweiten Anschluß des ersten Transistors TR1 verschaltet. Ein erster Anschluß des ersten Bipolartransistors BT1 und ein erster Anschluß des zweiten Bipolartransistors BT2 sind weiterhin gemeinsam mit einem zweiten Anschluß des zweiten MOS-Transistors MT2 und einem zweiten Anschluß des dritten Transistors TR3 verbunden, während ein zweiter Anschluß des zweiten Transistors TR2 und ein zweiter Anschluß des zweiten Bipolartransistors BT2 gemeinsam über einen ersten Widerstand W1 mit einer zweiten Klemme KL2 verschaltet sind. Ein zweiter Anschluß des ersten Bipolartransistors BT1 und ein zweiter Anschluß des dritten MOS-Transistors MT3 sind gemeinsam über einen zweiten Widerstand W2 ebenfalls mit der zweiten Klemme KL2 verbunden. Ein erster Eingang E1 ist nach Figur 4 mit einem Steueranschluß des ersten Transistors TR1, ein zweiter Eingang E2 mit einem Gateanschluß des ersten MOS-Transistors MT1 verbunden, während ein Steueranschluß des zweiten Transistors TR2 und ein Steueranschluß des dritten Transistors TR3 gemeinsam einen dritten Eingang E3 und ein Gateanschluß des zweiten MOS-Transistors MT2 und ein Gateanschluß des dritten MOS-Transistors MT3 gemeinsam einen vierten Eingang E4 bilden. Ein erster Carryeingang C für ein nicht invertiertes Carrysignal ist mit einem Basisanschluß des zweiten Bipolartransistors BT2 und ein zweiter Carryeingang C̅ für ein invertiertes Carrysignal ist mit einem Basisanschluß des ersten Bipolartransistors BT1 verbunden. Ein zweiter Anschluß des ersten Bipolartransistors BT1 und ein zweiter Anschluß des MOS-Transistors MT3 bilden gemeinsam einen ersten Carryausgang C0 für ein nicht invertiertes Carryausgangssignal und ein zweiter Anschluß des zweiten Transistors TR2 und ein zweiter Anschluß des zweiten Bipolartransistors BT2 stellen gemeinsam einen zweiten Carryausgang C̅0̅ für ein invertiertes Carrysignal dar. Im Carryteil nach Figur 4 ist die erste Klemme KL1 mit der Masse V_{SS} und die zweite Klemme KL2 mit der Versorgungsspannung V_{DD} beschaltet. Der erste MOS-Transistor MT1 ist in dem Carryteil ein n-Kanal-MOS-Transistor, der zweite und dritte MOS-Transistor MT2, MT3 ein p-Kanal-MOS-Transistor, während der erste, zweite und dritte Transistor TR1, TR2 und TR3 sowie der erste und zweite Bipolartransistor BT1, BT2 npn-Bipolartransistoren sind.

In diesem Ausführungsbeispiel werden die zu summierenden CMOS-Eingangssignale auf den zweiten und vierten Eingang E2, E4 geschaltet, während auf den ersten und dritten Eingang entsprechende Referenzsignale, innerhalb des Low- und High-Pegels der CMOS-Eingangssignale, angelegt werden.

Bei einem Vergleich des Summenteils nach Figur 2 und des Carryteils nach Figur 4 erkennt man, daß in beiden Schaltungen die Differenzverstärker nach einem "Series gating"-Prinzip verschaltet sind. Ebenfalls erkennt man, daß zeitkritische Pfade, beispielsweise der Carrypfad, in beiden Schaltungen in Bipolar- bzw. ECL-Technik ausgeführt ist, eine Pegelwandlung zwischen CMOS- und ECL-Pegel sowie eine logische Verknüpfung der Eingangssignale wird in beiden Schaltungen durch die ersten drei Differenzverstärker ausgeführt.

Eine weitere Variante des Carryteils nach Figur 4 ergibt sich dadurch, daß der erste MOS-Transistor MT1 und der erste Transistor TR1 ein n-Kanal-MOS-Transistor, der zweite und dritte MOS-Transistor MT2 und MT3 sowie der zweite und dritte Transistor TR2 und TR3 und p-Kanal-MOS-Transistor ist und der erste und zweite Bipolartransistor BT1, BT2 durch npn-Bipolartransistoren ausgeführt sind. Durch eine solche Ausführung ist es erforderlich, den Carryteil nach Figur 4 mit gegenphasigen Eingangssignalen zu betrieben. In diesem Falle weist das Eingangssignal am Eingang E1 ein gegenphasiges Eingangssignal auf zum zweiten Eingang E2 und das Eingangssignal am dritten Eingang E3 ein gegenphasiges Eingangssignal zum vierten Eingang E4. Der Vorteil dieser Variante liegt in einem geringeren Flächenbedarf, jedoch ist bei einer solchen Realisierung mit einer größeren Laufzeit der Eingangssignale in der Schaltung und somit mit einer niedrigen Verarbeitungsgeschwindigkeit zu rechnen.

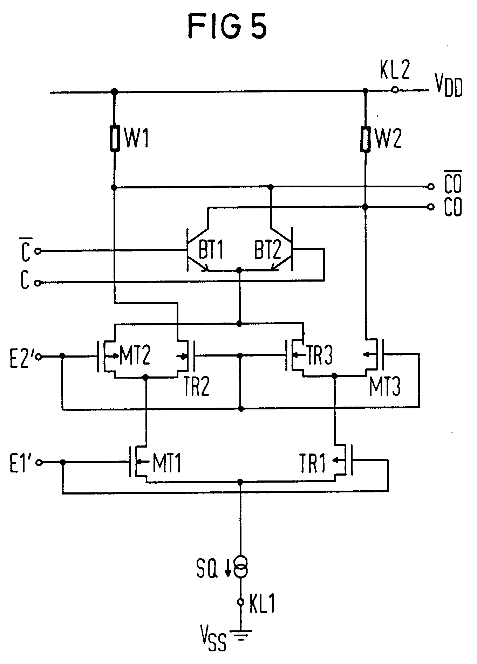

Figur 5 schließlich zeigt ein zweites Ausführungsbeispiel eines Carryteils für die Addierzelle, wobei der grundsätzliche Aufbau der Schaltung des Carryteils nach Figur 4 entspricht. Aus diesem Grunde werden auch gleiche Bezugszeichen in der Fig. 4 und der Fig.5 verwendet. Bipolare Transistoren in den ersten drei Differenzverstärkern sind hier wiederum durch MOS-Transistoren ersetzt und zwar so, daß jeweils komplementäre Transistoren einen Stromschalter bilden. Der erste MOS-Transistor MT1 und der zweite und dritte Transistor TR2 und TR3 sind dabei ein n-Kanal-MOS-Transistor und der zweite und dritte MOS-Transistor MT2, MT3 ein p-Kanal-MOS-Transistor, während der erste und zweite Bipolartransistor BT1, BT2 als npn-Bipolartransistoren ausgeführt sind. Diese Schaltung hat den Vorteil eines geringeren Flächenbedarfs. Es werden hierfür keine komplementären Eingangssignale erforderlich, so daß der erste und zweite Eingang E1, E2 zu einem ersten gemeinsamen Eingang E1′ und der dritte und vierte Eingang E3, E4 zu einem gemeinsamen zweiten Eingang E2′ zusammengefaßt werden können. Nachteilig an diesem zweiten Ausführungsbeispiel ist ebenfalls die etwas niedrigere Verarbeitungsgeschwindigkeit gegenüber der Schaltung nach Figur 4.

Die Wahl des MOS-Transistortyps n- bzw. p-Kanal bei den Schaltungen nach Figur 2 bis 5 erfolgt so, daß die MOS-Transistorgröße minimal ist, was von der jeweiligen Substratvorspannung des MOS-Transistors abhängt. Es ist ebenfalls möglich, jeweils nur einen MOS-Transistortyp in dem Summen- bzw. Carryteil zu verwenden.

Figur 6 zeigt eine Wahrheitstabelle für ein Carry- und Summenteil einer Addierzelle, die jeweils mit komplementären Eingangssignalen zu belegen sind. In diesem Falle sind in beiden Schaltungen der erste MOS-Transistor MT1 und der erste Transistor TR1 n-Kanal-MOS-Transistoren, der zweite und dritte MOS-Transistor MT2, MT3 und der zweite und dritte Transistor TR2 und TR3 ein p-Kanal-MOS-Transistor und der erste und zweite Bipolartransistor nach Fig. 4 bzw. der erste, zweite, dritte und vierte Bipolartransistor BT1, BT2, BT3 und BT4 nach Figur 2 ein npn-Bipolartransistor. In der ersten Spalte E1 = E̅2̅ sind die komplementären Eingangssignale zum zweiten Eingang E2 aufgezeigt, während im dritten Eingang E3 = E̅4̅ die komplementären Eingangssignale des vierten Eingang E4 aufgeführt sind. Ein erster und zweiter Carryeingang, C, C̅ für ein nicht invertiertes bzw. invertiertes Carrysignal sind ebenfalls in der Wahrheitstabelle nach Figur 6 angegeben. Für den Summenteil der Addierzelle sind die Ausgangssignale am Summenausgang S und S̅ in der Wahrheitstabelle aufgeführt, während für den Carryteil die Ausgangssignale am Carryausgang C0 bzw. C̅0̅ wiedergegeben sind.

Stellvertretend für die übrigen Zeilen gibt beispielsweise die dritte Zeile in der Wahrheitstabelle nach Figur 6 an, daß am Summenausgang S genau dann ein High-Pegel bzw. am Summenausgang S̅ ein Low-Pegel auftritt, falls der erste und vierte Eingang E1 und E4 sowie der Carryeingang C̅ mit einem High-Pegel und der zweite und dritte Eingang E2, E3 sowie der Carryeingang C mit einem Low-Pegel beschaltet ist. In diesem Falle können am Carryausgang C0 der Addierzelle ein Low-Pegel und am Carryausgang C̅0̅ ein High-Pegel abgegriffen werden. Für den Summen- bzw. Carryteil nach Figur 2 bzw. 4 bedeutet dies, daß der erste Transistor TR1 leitet und der erste MOS-Transistor MT1 sperrt, daß der zweite und dritte MOS-Transistor MT2, MT3 sperrt und der zweite und dritte Transistor TR2, TR3 leitet. Der erste und vierte Bipolartransistor BT1, BT4 im Summenteil nach Fig. 2 bzw. der erste Bipolartransistor BT1 im Carryteil nach Figur 4 ist durchgeschaltet, während der zweite und dritte Bipolartransistor BT2 und BT3 im Summenteil nach Fig. 2 bzw. der zweite Bipolartransistor BT2 im Carryteil nach Figur 4 gesperrt ist. Dies bewirkt im Summenteil nach Figur 2, daß am ersten Summenausgang S ein High-Pegel und am zweiten Summenausgang S̅ ein Low-Pegel und im Carryteil nach Figur 4 am ersten Carryausgang C0 ein Low-Pegel und ein zweiten Carryausgang C̅0̅ ein High-Pegel abgegriffen werden kann.

## Patentansprüche

1. Addierzelle mit einem Summen- und einem Carryteil, **dadurch gekennzeichnet**, daß der Summenteil einen ersten Differenzverstärker mit einem ersten MOS-Transistor (MT1) und einen ersten Transistor (TR1), einen zweiten Differenzverstärker mit einem zweiten MOS-Transistor (MT2) und einen zweiten Transistor (TR2), einen dritten Differenzverstärker mit einem dritten MOS-Transistor (MT3) und einen dritten Transistor (TR3) sowie einen vierten Differenzverstärker, bestehend aus einem ersten und zweiten Bipolartransistor (BT1, BT2), und einem fünften Differenzverstärker, bestehend aus einem dritten und vierten Bipolartransistor (BT3, BT4), einer Stromquelle (SQ) und einen ersten und zweiten Widerstand (W1, W2) enthält, daß ein erster Anschluß des ersten MOS-Transistors (MT1) und ein erster Anschluß des ersten Transistors (TR1) gemeinsam über die Stromquelle (SQ) mit einer ersten Klemme (KL1) verbunden ist, daß ein erster Anschluß des zweiten MOS-Transistors (MT2) und ein erster Anschluß des zweiten Transistors (TR2) mit einem zweiten Anschluß des ersten MOS-Transistors (MT1) und ein erster Anschluß des dritten MOS-Transistors (MT3) und ein erster Anschluß des dritten Transistors (TR3) mit einem zweiten Anschluß des ersten Transistors (TR1) verschaltet ist, daß ein erster Anschluß des ersten Bipolartransistor (BT1) und ein erster Anschluß des zweiten Bipolartransistors (BT2) an einen zweiten Anschluß des zweiten MOS-Transistors (MT2) und an einen zweiten Anschluß des dritten Transistors (TR3) geschaltet ist, daß ein erster Anschluß des dritten Bipolartransistors (BT3) und ein erster Anschluß des vierten Bipolartransistors (BT4) mit einem zweiten Anschluß des zweiten Transistors (TR2) und einem zweiten Anschluß des dritten MOS-Transistors (MT3) verschaltet ist, daß ein zweiter Anschluß des ersten Bipolartransistors (BT1) und ein zweiter Anschluß des dritten Bipolartransistors (BT3) gemeinsam über einen ersten Widerstand (W1) mit einer zweiten Klemme (KL2) verschaltet ist, daß ein zweiter Anschluß des zweiten Bipolartransistors (BT2) und ein zweiter Anschluß des vierten Bipolartransistors (BT4) gemeinsam über den zweiten Widerstand (W2) mit der zweiten Klemme (KL2) verbunden ist, daß ein erster Eingang (E1) mit einem Steueranschluß des ersten Transistors (TR1) und ein zweiter Eingang (E2) mit einem Gateanschluß des ersten MOS-Transistors (MT1) verschaltet ist, daß ein Steueranschluß des zweiten Transistors (TR2) und ein Steueranschluß des dritten Transistors (TR3) gemeinsam einen dritten Eingang (E3) bilden, daß ein Gateanschluß des zweiten MOS-Transistors (MT2) und ein Gateanschluß des dritten MOS-Transistors (MT3) gemeinsam einen vierten Eingang (E4) bilden, daß ein erster Carryeingang (C) an einen Basisanschluß des zweiten Bipolartransistors (BT2) und an einen Basisanschluß des dritten Bipolartransistors (BT3) geschaltet ist, daß ein zweiter Carryeingang (C̅) mit einem Basisanschluß des ersten Bipolartransistors (BT1) und mit einem Basisanschluß des vierten Bipolartransistors (BT4) verbunden ist, daß ein erster Summenausgang (S) mit dem zweiten Anschluß des vierten Bipolartransistors (BT4) und dem zweiten Anschluß des zweiten Bipolartransistors (BT2) verschaltet ist, daß ein zweiter Summenausgang (S̅) mit dem zweiten Anschluß des ersten Bipolartransistors (BT1) und dem zweiten Anschluß des dritten Bipolartransistors (BT3) verbunden ist.

2. Addierzelle nach Anspruch 1, **dadurch gekennzeichnet**, daß im Summenteil der erste MOS-Transistor (MT1) ein n-Kanal-MOS-Transistor, der zweite und dritte MOS-Transistor (MT2, MT3) ein p-Kanal-MOS-Transistor und der erste, zweite und dritte Transistor (TR1, TR2, TR3) sowie der erste, zweite, dritte und vierte Bipolartransistor (BT1, BT2, BT3, BT4) ein npn-Bipolartransistor ist.

3. Addierzelle nach Anspruch 1, **dadurch gekennzeichnet**, daß im Summenteil der erste MOS-Transistor (MT1) und der erste Transistor (TR1) ein n-Kanal-MOS-Transistor, der zweite und dritte MOS-Transistor (MT2, MT3) und der zweite und dritte Transistor (TR2, TR3) ein p-Kanal-MOS-Transistor und der erste, zweite, dritte und vierte Bipolartransistor (BT1, BT2, BT3, BT4) ein npn-Bipolartransistor ist.

4. Addierzelle nach Anspruch 1, **dadurch gekennzeichnet**, daß im Summenteil der erste MOS-Transistor (MT1), der zweite und dritte Transistor (TR2, TR3) ein n-Kanal-MOS-Transistor, der erste Transistor (TR1) und der zweite und dritte MOS-Transistor (MT2, MT3) ein p-Kanal-MOS-Transistor und der erste, zweite, dritte und vierte Bipolartransistor (BT1, BT2, BT3, BT4) ein npn-Bipolartransistor ist, daß der erste und zweite Eingang (E1, E2) einen ersten gemeinsamen Eingang (E1′) und der dritte und vierte Eingang (E3, E4) einen zweiten gemeinsam Eingang (E2′) bilden.

5. Addierzelle mit einem Summen- und einem Carryteil, **dadurch gekennzeichnet**, daß der Carryteil einen ersten Differenzverstärker mit einem ersten MOS-Transistor (MT1) und einem ersten Transistor (TR1), einen zweiten Differenzverstärker mit einem zweiten MOS-Transistor (MT2) und einem zweiten Transistor (TR2), einen dritten Differenzverstärker mit einem dritten MOS-Transistor (MT3) und einem dritten Transistor (TR3) und einen vierten Differenzverstärker, bestehend aus einem ersten und zweiten Bipolartransistor (BT1, BT2), eine Stromquelle (SQ) und einen ersten und zweiten Widerstand (W1, W2) enthält, daß ein erster Anschluß des ersten MOS-Transistors (MT1) und ein erster Anschluß des ersten Transistors (TR1) gemeinsam über die Stromquelle (SQ) mit einer ersten Klemme (KL1) verbunden ist, daß ein erster Anschluß des zweiten MOS-Transistors (MT2) und ein erster Anschluß des zweiten Transistors (TR2) mit einem zweiten Anschluß des ersten MOS-Transistors (MT1) und ein erster Anschluß des dritten Transistors (T3) und ein erster Anschluß des dritten MOS-Transistors (MT3) mit einem zweiten Anschluß des ersten Transistors (TR1) verschaltet ist, daß ein erster Anschluß des ersten Bipolartransistor (BT1) und ein erster Anschluß des zweiten Bipolartransistors (BT2) mit einem zweiten Anschluß des zweiten MOS-Transistors (MT2) und einem zweiten Anschluß des dritten Transistors (TR3) verbunden ist, daß ein zweiter Anschluß des zweiten Transistors (TR2) und ein zweiter Anschluß des zweiten Bipolartransisors (BT2) gemeinsam über einen ersten Widerstand (W1) mit einer zweiten Klemme (KL2) und ein zweiter Anschluß des ersten Bipolartransistors (BT1) und ein zweiter Anschluß des dritten MOS-Transistors (MT3) gemeinsam über einen zweiten Widerstand (W2) mit der zweiten Klemme (KL2) verschaltet ist, daß ein erster Eingang (E1) mit einem Steueranschluß des ersten Transistors (TR1) und ein zweiter Eingang (E2) mit einem Gateanschluß des ersten MOS-Transistors (MT1) verbunden ist, daß ein Steueranschluß des zweiten Transistors (TR2) und ein Steueranschluß des dritten Transistors (TR3) gemeinsam einen dritten Eingang (E3) bilden, daß ein Gateanschluß des zweiten MOS-Transistors (MT2) und ein Gateanschluß des dritten MOS-Transistors (MT3) gemeinsam einen vierten Eingang (E4) bilden, daß ein erster Carryeingang (C) mit einem Basisanschluß des zweiten Bipolartransistors (BT2) und ein zweiter Carryeingang (C̅) mit einem Basisanschluß des ersten Bipolartransistors (BT1) verschaltet ist, daß ein zweiter Anschluß des ersten Bipolartransistors (BT1) und ein zweiter Anschluß des dritten MOS-Transistors (MT3) gemeinsam einen ersten Carryausgang (C0) und ein zweiter Anschluß des zweiten Transistors (TR2) und ein zweiter Anschluß des zweiten Bipolartransistors (BT2) gemeinsam einen zweiten Carryausgang (C̅0̅) bilden.

6. Addierzelle nach Anspruch 5, **dadurch gekennzeichnet**, daß im Carryteil der erste MOS-Transistor (MT1) ein n-Kanal-MOS-Transistor, der zweite und dritte MOS-Transistor (MT2, MT3) ein p-Kanal-MOS-Transistor und der erste, zweite und dritte Transistor (TR1, TR2, TR3) sowie der erste und zweite Bipolartransistor (BT1, BT2) ein npn-Bipolartransistor ist.

7. Addierzelle nach Anspruch 5, **dadurch gekennzeichnet**, daß im Carryteil der erste MOS-Transistor (MT1) und der erste Transistor (TR1) ein n-Kanal-MOS-Transistor, der zweite und dritte MOS-Transistor (MT2, MT3) sowie der zweite und dritte Transistor (TR2, TR3) ein p-Kanal-MOS-Transistor und der erste und zweite Bipolartransistor (BT1, BT2) ein npn-Bipolartransistor ist.

8. Addierzelle nach Anspruch 5, **dadurch gekennzeichnet**, daß im Carryteil der erste MOS-Transistor (MT1) und der zweite und dritte Transistor (TR2, TR3) ein n-Kanal-MOS-Transistor, der zweite und dritte MOS-Transistor (MT2, MT3) ein p-Kanal-MOS-Transistor und der erste und zweite Bipolartransistor (BT1, BT2) ein npn-Bipolartransistor ist, daß der erste und zweite Eingang (E1, E2) einen ersten gemeinsamen Eingang (E1′) und der dritte und vierte Eingang (E3, E4) einen zweiten gemeinsamen Eingang (E2′) bilden.

9. Addierzelle mit einem Summen- und einem Carryteil nach einem der Ansprüche 1 bis 8, **dadurch gekennzeichnet**, daß die erste Klemme (KL1) mit der Masse (V_{SS}) und die zweite Klemme (KL2) mit der Versorgungsspannung (V_{DD}) verschaltet ist.

## Claims

1. Adder cell having a sum part and a carry part, characterized in that the sum part contains a first differential amplifier with a first MOS transistor (MT1) and a first transistor (TR1), a second differential amplifier with a second MOS transistor (MT2) and a second transistor (TR2), a third differential amplifier with a third MOS transistor (MT3) and a third transistor (TR3), as well as a fourth differential amplifier, comprising first and second bipolar transistors (BT1, BT2), and a fifth differential amplifier, comprising third and fourth bipolar transistors (BT3, BT4), a current source (SQ) and first and second resistors (W1, W2), in that a first terminal of the first MOS transistor (MT1) and a first terminal of the first transistor (TR1) are connected jointly via the current source (SQ) to a first circuit terminal (KL1), in that a first terminal of the second MOS transistor (MT2) and a first terminal of the second transistor (TR2) are connected to a second terminal of the first MOS transistor (MT1), and a first terminal of the third MOS transistor (MT3) and a first terminal of the third transistor (TR3) are connected to a second terminal of the first transistor (TR1), in that a first terminal of the first bipolar transistor (BT1) and a first terminal of the second bipolar transistor (BT2) are connected to a second terminal of the second MOS transistor (MT2) and to a second terminal of the third transistor (TR3), in that a first terminal of the third bipolar transistor (BT3) and a first terminal of the fourth bipolar transistor (BT4) are connected to a second terminal of the second transistor (TR2) and to a second terminal of the third MOS transistor (MT3), in that a second terminal of the first bipolar transistor (BT1) and a second terminal of the third bipolar transistor (BT3) are connected jointly via a first resistor (W1) to a second circuit terminal (KL2), in that a second terminal of the second bipolar transistor (BT2) and a second terminal of the fourth bipolar transistor (BT4) are connected jointly via the second resistor (W2) to the second circuit terminal (KL2), in that a first input (E1) is connected to a control terminal of the first transistor (TR1) and a second input (E2) is connected to a gate terminal of the first MOS transistor (MT1), in that a control terminal of the second transistor (TR2) and a control terminal of the third transistor (TR3) together form a third input (E3), in that a gate terminal of the second MOS transistor (MT2) and a gate terminal of the third MOS transistor (MT3) together form a fourth input (E4), in that a first carry input (C) is connected to a base terminal of the second bipolar transistor (BT2) and to a base terminal of the third bipolar transistor (BT3), in that a second carry input (C̅) is connected to a base terminal of the first bipolar transistor (BT1) and to a base terminal of the fourth bipolar transistor (BT4), in that a first sum output (S) is connected to the second terminal of the fourth bipolar transistor (BT4) and to the second terminal of the second bipolar transistor (BT2), and in that a second sum output (S̅) is connected to the second terminal of the first bipolar transistor (BT1) and to the second terminal of the third bipolar transistor (BT3).

2. Adder cell according to Claim 1, characterized in that in the sum part the first MOS transistor (MT1) is an n-channel MOS transistor, the second and third MOS transistors (MT2, MT3) are p-channel MOS transistors, and the first, second and third transistors (TR1, TR2, TR3) as well as the first, second, third and fourth bipolar transistors (BT1, BT2, BT3, BT4) are npn bipolar transistors.

3. Adder cell according to Claim 1, characterized in that in the sum part the first MOS transistor (MT1) and the first transistor (TR1) are n-channel MOS transistors, the second and third MOS transistors (MT2, MT3) and the second and third transistors (TR2, TR3) are p-channel MOS transistors, and the first, second, third and fourth bipolar transistors (BT1, BT2, BT3, BT4) are npn bipolar transistors.

4. Adder cell according to Claim 1, characterized in that in the sum part the first MOS transistor (MT1) and the second and third transistors (TR2, TR3) are n-channel MOS transistors, the first transistor (TR1) and the second and third MOS transistors (MT2, MT3) are p-channel MOS transistors, and the first, second, third and fourth bipolar transistors (BT1, BT2, BT3, BT4) are npn bipolar transistors, and in that the first and second inputs (E1, E2) form a first common input (E1′) and the third and fourth inputs (E3, E4) form a second common input (E2′).

5. Adder cell having a sum part and a carry part, characterized in that the carry part contains a first differential amplifier with a first MOS transistor (MT1) and a first transistor (TR1), a second differential amplifier with a second MOS transistor (MT2) and a second transistor (TR2), a third differential amplifier with a third MOS transistor (MT3) and a third transistor (TR3), and a fourth differential amplifier, comprising first and second bipolar transistors (BT1, BT2), a current source (SQ) and first and second resistors (W1, W2), in that a first terminal of the first MOS transistor (MT1) and a first terminal of the first transistor (TR1) are connected jointly via the current source (SQ) to a first circuit terminal (KL1), in that a first terminal of the second MOS transistor (MT2) and a first terminal of the second transistor (TR2) are connected to a second terminal of the first MOS transistor (MT1), and a first terminal of the third transistor (T3) and a first terminal of the third MOS transistor (MT3) are connected to a second terminal of the first transistor (TR1), in that a first terminal of the first bipolar transistor (BT1) and a first terminal of the second bipolar transistor (BT2) are connected to a second terminal of the second MOS transistor (MT2) and to a second terminal of the third transistor (TR3), in that a second terminal of the second transistor (TR2) and a second terminal of the second bipolar transistor (BT2) are connected jointly via a first resistor (W1) to a second circuit terminal (KL2), and a second terminal of the first bipolar transistor (BT1) and a second terminal of the third MOS transistor (MT3) are connected jointly via a second resistor (W2) to the second circuit terminal (KL2), in that a first input (E1) is connected to a control terminal of the first transistor (TR1) and a second input (E2) is connected to a gate terminal of the first MOS transistor (MT1), in that a control terminal of the second transistor (TR2) and a control terminal of the third transistor (TR3) together form a third input (E3), in that a gate terminal of the second MOS transistor (MT2) and a gate terminal of the third MOS transistor (MT3) together form a fourth input (E4), in that a first carry input (C) is connected to a base terminal of the second bipolar transistor (BT2) and a second carry input (C̅) is connected to a base terminal of the first bipolar transistor (BT1), and in that a second terminal of the first bipolar transistor (BT1) and a second terminal of the third MOS transistor (MT3) together form a first carry output (CO), and a second terminal of the second transistor (TR2) and a second terminal of the second bipolar transistor (BT2) together form a second carry output (C̅O̅).

6. Adder cell according to Claim 5, characterized in that in the carry part the first MOS transistor (MT1) is an n-channel MOS transistor, the second and third MOS transistors (MT2, MT3) are p-channel MOS transistors, and the first, second and third transistors (TR1, TR2, TR3) as well as the first and second bipolar transistors (BT1, BT2) are npn bipolar transistors.

7. Adder cell according to Claim 5, characterized in that in the carry part the first MOS transistor (MT1) and the first transistor (TR1) are n-channel MOS transistors, the second and third MOS transistors (MT2, MT3) as well as the second and third transistors (TR2, TR3) are p-channel MOS transistors, and the first and second bipolar transistors (BT1, BT2) are npn bipolar transistors.

8. Adder cell according to Claim 5, characterized in that in the carry part the first MOS transistor (MT1) and the second and third transistors (TR2, TR3) are n-channel MOS transistors, the second and third MOS transistors (MT2, MT3) are p-channel MOS transistors, and the first and second bipolar transistors (BT1, BT2) are npn bipolar transistors, and in that the first and second inputs (E1, E2) form a first common input (E1′) and the third and fourth inputs (E3, E4) form a second common input (E2′).

9. Adder cell having a sum part and a carry part according to one of Claims 1 to 8, characterized in that the first circuit terminal (KL1) is connected to ground (V_{SS}) and the second circuit terminal (KL2) is connected to the supply voltage (V_{DD}).

## Revendications

1. Cellule d'addition ayant une partie de somme et une partie de retenue, caractérisée en ce que la partie de somme comporte un premier amplificateur différentiel comportant un premier transistor MOS (MT1), un premier transistor (TR1), un deuxième amplificateur différentiel ayant un deuxième transistor MOS (MT2), un deuxième transistor (TR2), un troisième amplificateur différentiel ayant un troisième transistor MOS (MT3), un troisième transistor (TR3) ainsi qu'un quatrième amplificateur différentiel constitué d'un premier et d'un second transistors bipolaires (BT1, BT2) et un cinquième amplificateur différentiel constitué d'un troisième et d'un quatrième transistor bipolaire (BT3, BT4), d'une source de courant (SQ) et d'une première et deuxième résistance (W1, W2), une première borne du premier transistor MOS (MTl) et une première borne du premier transistor (TR1) sont reliées en commun par l'intermédiaire de la source (SQ) de courant à une première borne (KL1), une première borne du deuxième transistor MOS (MT2) et une première borne du deuxième transistor (TR2) sont connectées à une deuxième borne du premier transistor MOS (MT1) et une première borne du troisième transistor MOS (MT3) et une première borne du troisième transistor (TR3) sont connectées à une deuxième borne du premier transistor (TR1), une première borne du premier transistor bipolaire (BT1) et une première borne du deuxième transistor bipolaire (BT2) sont connectées à une deuxième borne du deuxième transistor MOS (MT2) et à une deuxième borne du troisième transistor (TR3), une première borne du troisième transistor bipolaire (BT3) et une première borne du quatrième transistor bipolaire (BT4) sont connectées à une deuxième borne du deuxième transistor (TR2) et à une deuxième borne du troisième transistor MOS (MT3), une deuxième borne du premier transistor bipolaire (BT1) et une deuxième borne du troisième transistor bipolaire (BT3) sont connectées en commun par l'intermédiaire d'une première résistance (W1) à une deuxième borne (KL2), une deuxième borne du deuxième transistor bipolaire (BT2) et une deuxième borne du quatrième transistor bipolaire (BT4) sont reliées en commun par l'intermédiaire de la deuxième résistance (W2) à la deuxième borne (KL2), une première entrée (E1) est connectée à une borne de commande du premier transistor (TR1) et une deuxième entrée (E2) est connectée à une borne de grille du premier transistor MOS (MT1), une borne de commande du deuxième transistor (TR2) et une borne de commande du troisième transistor (TR3) forment en commun une troisième entrée (E3), une borne de grille du deuxième transistor MOS (MT2) et une borne de grille du troisième transistor MOS (MT3) forment en commun une quatrième entrée (E4), une première entrée (C) de retenue est connectée à une borne de base du deuxième transistor bipolaire (BT2) et à une borne de base du troisième transistor bipolaire (BT3), une deuxième entrée (C̅) de retenue est reliée à une borne de base du premier transistor bipolaire (BT1) et à une borne de base du quatrième transistor bipolaire (BT4), une première sortie (S) de somme est connectée à la deuxième borne du quatrième transistor bipolaire (BT4) et à la deuxième borne du deuxième transistor bipolaire (BT2), une deuxième sortie (S̅) de somme est reliée à la deuxième borne du premier transistor bipolaire (BT1) et à la deuxième borne du troisième transistor bipolaire (BT3).

2. Cellule d'addition suivant la revendication 1, caractérisée en ce que dans la partie de somme le premier transistor MOS (MT1) est un transistor MOS à canal n, les second et troisième transistors MOS (MT2, MT3) sont des transistors MOS à canal p et les premier, deuxième et troisième transistors (TR1, TR2, TR3) ainsi que les premier, deuxième, troisième et quatrième transistors bipolaires (BT1, BT2, BT3, BT4) sont des transistors bipolaires npn.

3. Cellule d'addition suivant la revendication 1, caractérisée en ce que dans la partie de somme le premier transistor MOS (MT1) et le premier transistor (TR1) sont des transistors MOS à canal n, les deuxième et troisième transistors MOS (MT2, MT3) et les deuxième et troisième transistors (TR2, TR3) sont des transistors MOS à canal p et les premier, deuxième, troisième et quatrième transistors bipolaires (BT1, BT2, BT3, BT4) sont des transistors bipolaires npn.

4. Cellule d'addition suivant la revendication 1, caractérisée en ce que dans la partie de somme, le premier transistor MOS (MT1), les deuxième et troisième transistors (TR2, TR3) sont des transistors MOS à canal n, le premier transistor (TR1) et les deuxième et troisième transistors MOS (MT2, MT3) sont des transistors MOS à canal p, et les premier, deuxième, troisième et quatrième transistors bipolaires (BT1 , BT2, BT3, BT4) sont des transistors bipolaires npn, les première et seconde entrées (E1, E2) forment une première entrée commune (E1′) et les troisième et quatrième entrées (E3, E4) forment une deuxième entrée commune (E2′).

5. Cellule d'addition ayant une partie de somme et une partie de retenue, caractérisée en ce que la partie de retenue comporte un premier amplificateur différentiel comportant un premier transistor MOS (MT1) et un premier transistor (TR1), un deuxième amplificateur différentiel comportant un deuxième transistor MOS (MT2) et un deuxième transistor (TR2), un troisième amplificateur différentiel comportant un troisième transistor MOS (MT3) et un troisième transistor (TR3), un quatrième amplificateur différentiel, constitué d'un premier et d'un second transistors bipolaires (BT1, BT2), une source (SQ) de courant et une première et une seconde résistance (W1, W2), une première borne du premier transistor MOS (MT1) et une première borne du premier transistor (TR1) sont reliées en commun par l'intermédiaire de la source (SQ) de courant à une première borne (KL1), une première borne du deuxième transistor MOS (MT2) et une première borne du deuxième transistor (TR2) sont connectées à une deuxième borne du premier transistor MOS (MT1) et une première borne du troisième transistor (T3) et une première borne du troisième transistor MOS (MT3) sont connectées à une deuxième borne du premier transistor (TR1), une première borne du premier transistor bipolaire (BT1) et une première borne du deuxième transistor bipolaire (BT2) sont reliées à une deuxième borne du deuxième transistor MOS (MT2) et à une deuxième borne du troisième transistor (TR3), une deuxième borne du deuxième transistor (TR2) et une deuxième borne du deuxième transistor bipolaire (BT2) sont connectées en commun par l'intermédiaire d'une première résistance (W1) à une deuxième borne (KL2) et une deuxième borne du premier transistor bipolaire (BT1) et une deuxième borne du troisième transistor MOS (MT3) sont connectées en commun par l'intermédiaire d'une deuxième résistance (W2) à la deuxième borne (KL2), une première entrée (E1) est reliée à une entrée de commande du premier transistor (TR1) et une deuxième entrée (E2) est reliée à une entrée de grille du premier transistor MOS (MT1), une borne de commande du deuxième transistor (TR2) et une borne de commande du troisième transistor (TR3) forment en commun une troisième entrée (E3), une borne de grille du deuxième transistor MOS (MT2) et une borne de grille du troisième transistor MOS (MT3) forment en commun une quatrième entrée (E4), une première entrée (C̅) de retenue est connectée à une borne de base du deuxième transistor bipolaire (BT2) et une deuxième entrée de retenue est reliée à une borne de base du premier transistor bipolaire (BT1), une deuxième borne du premier transistor bipolaire (BT1) et une deuxième borne du troisième transistor MOS (MT3) forment en commun une première sortie (CO) de retenues et une deuxième borne du deuxième transistor (TR2) et une deuxième borne du deuxième transistor bipolaire (BT2) forment en commun une deuxième sortie (C̅O̅) de retenue.

6. Cellule d'addition suivant la revendication 5, caractérisée en ce que dans la partie de retenue, le premier transistor MOS (MT1) est un transistor MOS à canal n, les deuxième et troisième transistors MOS (MT2, MT3) sont des transistors MOS à canal p et les premier, deuxième et troisième transistors (TR1, TR2, TR3) ainsi que les premier et deuxième transistors bipolaires (BT1, BT2) sont des transistors bipolaires npn.

7. Cellule d'addition suivant la revendication 5, caractérisée en ce que, dans la partie de retenue, le premier transistor MOS (MT1) et le premier transistor (TR1) sont des transistors MOS à canal n, les deuxième et troisième transistors MOS (MT2, MT3) ainsi que les deuxième et troisième transistors (TR2, TR3) sont des transistors MOS à canal p et les premier et deuxième transistors bipolaires (BT1, BT2) sont des transistors bipolaires npn.

8. Cellule d'addition suivant la revendication 5, caractérisée en ce que, dans la partie de retenue, le premier transistor MOS (MT1) et les deuxième et troisième transistors (TR2, TR3) sont des transistors MOS à canal n, les deuxième et troisième transistors MOS (MT2, MT3) sont des transistors MOS à canal p, les premier et deuxième transistors bipolaires (BT1, BT2) sont des transistors bipolaires npn, les première et deuxième entrées (E1, E2) forment une première entrée commune (E1′) et les troisième et quatrième entrées (E3, E4) forment une deuxième entrée commune (E2′).

9. Cellule d'addition ayant une partie de somme et une partie de retenue suivant l'une des revendications 1 à 8, caractérisée en ce que la première borne (KL1) est connectée à la masse (V_{SS}) et la deuxième borne (KL2) est connectée à la tension (V_{DD}) d'alimentation.
